Europäisches Patentamt

European Patent Office

Office européen des brevets

(19)

(11) **EP 0 612 149 B1**

(12) **EUROPEAN PATENT SPECIFICATION**

(45) Date of publication and mention
of the grant of the patent:
**24.06.1998  Bulletin 1998/26**

(51) Int Cl.$^6$: **H03H 21/00**

(21) Application number: **93102558.9**

(22) Date of filing: **18.02.1993**

(54) **Method for adjusting an adaptive exponential filter and adaptive exponential filter**

Methode zur Einstellung eines adaptiven Exponentialfilters und adaptives Exponentialfilter

Méthode d'ajustement de filtre adaptif exponentiel et filtre adaptif exponentiel

(84) Designated Contracting States:
**AT BE CH DE DK ES FR GB GR IE IT LI LU MC NL PT SE**

(43) Date of publication of application:
**24.08.1994  Bulletin 1994/34**

(73) Proprietor: **DOW DEUTSCHLAND INC.**
**D-21677 Stade (DE)**

(72) Inventors:
• **Walter, Hilger A.**
  **D-21680 Stade (DE)**
• **Quelle, Ernst**
  **D-21682 Stade (DE)**

• **Nazer, Yahya**
  **Alberta T8B 1C7 (CA)**

(74) Representative: **Betten & Resch**
**Reichenbachstrasse 19**
**80469 München (DE)**

(56) References cited:
**EP-A- 0 070 961**

• **IEEE TRANSACTIONS ON ACOUSTICS, SPEECH AND SIGNAL PROCESSING vol. 30, no. 2, April 1982, NEW YORK US pages 322 - 329 R.DAVIS ET AL 'BIAS AND VARIANCE OF SPECTRAL ESTIMATES FROM AN ALL-POLE DIGITAL FILTER'**

## Description

The invention relates to a method for adjusting an adaptive exponential filter and an adaptive exponential filter. The invention is useful in the reduction of the noise component in a signal representing the value of the measurement. The input of the filter is supplied with a series of time-discrete input signals containing both a data component (or the value representing the measurement) and a noise component (or a distortion of the value representing the measurement). Within a process control context, the invention further relates to the use of the adaptive exponential filter in a control loop, a control loop, and a method for controlling a control loop.

Adaptive filters are filters that have the ability to adjust their own parameters automatically. They can be used to diminish the adverse effects of noise distortion in processing signals in a number of applications such as noise cancellation or noise reduction, echo canceller, leakage compensation, line equalization, speech processing, or the like. In this connection the term "noise" is used to signify all forms of interference.

In the case of process control, noise signals can either be produced in the process system (to which measurements are applied) as process noise or in the measurement system as measurement noise. It is usually not possible to identify the source of noise in a signal through the use of conventional analytical techniques on the time discrete signals themselves. Usually, noise will demonstrate an oscillatory or vibrational characteristic when a series of discrete signals is analyzed as a function of time; usually, the overall oscillatory pattern can be resolved into a set of sine waves having characteristic frequencies.

Process noise is produced from transient variations in the process system itself in the regions proximate to the location of the measuring sensor. There are a variety of factors that can contribute to such variations in the process system itself such as the presence of entrained gas bubbles in a liquid, local variations in a liquid density as in the case of agitated oil/water mixtures, local variations in liquid temperature, turbulence, or the like.

Measurement noise is produced in each stage of the measurement system. The measurement noise is usually a function of the quality of the measurement system.

Current methods used to measure process variables such as temperature, pressure, and flow inherently yield signals which incorporate both process noise and measurement noise in their magnitude. Hence, using a process signal corrupted by noise is a long-standing problem of process control engineers. When steady state or average values are needed by the system receiving the measurements, as in the case where an energy or mass balance is to be calculated, conventional filtering techniques will reduce the effects of the higher frequency portion of the noisy signal significantly. However, response by such filters to lower frequency process fluctuation noise will have a considerable phase lag which will continue to induce uncertainty in the representative character of the value of the signal being output from the filter.

The successful design of a filter to minimize the effects of the noisy signal is based upon the understanding of the types and nature of the noise in the measurement of chemical processes, operating equipment, machinery, or the like.

Natural phenomena, such as noise, are usually not uniformly distributed. Instead, they are more likely to follow a normal distribution also known as Gaussian Distribution which has well-known bell-shaped distribution properties. Random numbers generated by this distribution tend to cluster about the mean or average value of the entire group. As values depart from the mean, they occur less frequently.

The most commonly used filter for noise reduction in the field of process control is an exponential filter. Such exponential filters are designed to filter digital (usually time-discrete) input signals. Such input signals can be any digital signals, i.e. digital signals resulting from a process of analog to digital conversion of respective currents or voltages which have been output from transducers measuring characteristics of a chemical manufacturing process where such digital signals are then used in a process control computer which is controlling or operating said chemical manufacturing process through the generation of output signals to various valves, pumps, and motors. Such signals are corrupted by noise and contain both data of value and noise which usually tends to distort said data of value.

With $x_k$ as filter input signal (which is also the digitized discrete process output signal representing the measurement of some variable in said process at current sampling periods), $y_{k-1}$ as the delayed filter output signal from the prior sampling period, and k as the time index, the filter output signal $y_k$ for the current sampling period is defined by

$$y_k = (1 - F_k) \cdot y_{k-1} + F_k \cdot x_k \qquad (1)$$

where $F_k$ is the discrete filter time constant being defined by

$$F_k = 1 - e^{-T_s/T_p} \qquad (2)$$

with the sampling period $T_s$ and the continuous filter time constant $T_p$.

It should be noted that the term "time constant" when used in this disclosure derives from the traditional art and lexicon of process control and instrument engineering. Although the traditional terminology has been utilized in this disclosure, the literal meaning of the word "constant" with its connotation of "unvarying" may, in some cases, be somewhat altered in the context of the present disclosure since the value of a "time constant" might, in some cases, be recalculated at various times and will, therefore, "vary" with time when time is viewed in an extended context. Notwithstanding, the terminology is still valid when considered by one skilled in the art because of its traditional use in referencing certain components of formulae related to process dynamics.

Conventional exponential filters are adjusted by adjusting the sampling period $T_s$ and the continuous filter time constant $T_p$ according to complicated rules, whereby the discrete filter time constant $F_k$ is adjusted according to equation (2).

One object of the invention is to provide a method for easily adjusting the optimal discrete time constant of an exponential filter in correspondence with a current time-discrete input signal supplied to the input of the filter.

Another object is to provide an adaptive exponential filter, the optimal discrete time constant of which can easily be adjusted in correspondence with a current time-discrete input signal supplied to the input of the filter.

According to the invention, a method for adjusting an adaptive exponential filter is provided, the input to which is supplied with a series of time-discrete input signals containing both data and noise and wherein an estimate of the standard deviation of the filter input signal has been determined prior to the execution of the adaptive exponential filter method, which method comprises the steps of measuring the deviation between the current input signal to the adaptive exponential filter and the prior sample period's output signal from the exponential filter, determining the proportion of said deviation to said estimate of the standard deviation, and adjusting the discrete time constant of the filter in response to said proportion to provide a filtered output signal at the output of the adaptive exponential filter.

The adaptive exponential filter according to the invention, wherein an estimate of the standard deviation of the filter input signal has been determined before, comprises a means for measuring the deviation between the current input signal to the adaptive exponential filter and the prior sample period's output signal from the exponential filter, a means for determining the proportion of said deviation to said estimate of the standard deviation, and a means for adjusting the discrete time constant of the filter in response to said proportion to provide a filtered output signal at the output of the adaptive exponential filter.

The above and further objects and advantages of the invention may be understood better by referring to the following detailed description, which should be read in conjunction with the accompanying drawings in which:

Figure 1 shows, in a simplified block diagram form, a control loop with an adaptive digital filter according to the present invention;

Figure 2 is a flow chart showing the steps of the method for adjusting an adaptive digital filter according to the present invention; and

Figure 3 is an illustration of an exemplary functional relationship between the discrete filter time constant and the proportion of the deviation of the current input signal from the output signal of the filter to the estimate of the standard deviation of the filter input signal.

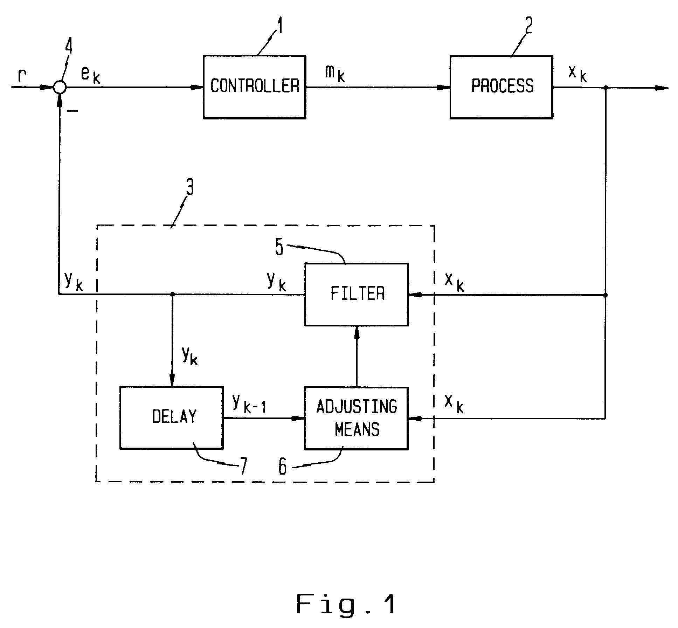

Figure 1 shows, in a simplified block diagram form, a control loop comprising a controller 1, a controlled system or process 2, and an adaptive filter 3.

A reference input signal r is supplied to a combining circuit 4 which can be either an adder where one of the inputs has been negated or a subtractor. In Figure 1, the output from the adaptive filter 3 is negated and supplied to the combining circuit 4. The output from the combining circuit 4 is supplied as error signal $e_k$ (with k being a time index) to the controller 1 which produces a manipulated input $m_k$ to the process 2 as an output from the controller 1.

The process 2 can be any mechanical or chemical process such as a reactor, a container to be filled, a thyristor, a motor, or the like.

The filter input signal $x_k$ (which is also the digitized discrete process output signal representing the measurement of some variable in process 2 at current sampling periods), which can be any process variable such as temperature, flow, voltage, current, r.p.m., or the like, is supplied to the adaptive filter 3 comprising an exponential filter 5, an adjusting means 6, and a delay means 7. The filter output signal $y_k$ from the exponential filter 5 is supplied to the combining circuit 4.

The filter input signal $x_k$ which is output from the process 2 is sampled with a sample interval (or period) $T_s$ which can be one second or any other time depending on the steadiness of the process, the measuring devices, and other circumstances. This sampled filter input signal $x_k$, with k being the time index of the discrete time, is supplied as a series of time-discrete input signals to the exponential filter 5 and the adjusting means 6 of the adaptive filter 3.

The filter output signal $y_k$ (at the discrete time associated with the value of time index k, i.e. the current sampling period) of the exponential filter 5 is also supplied to the delay means 7 which delays the filter output signal $y_k$ (of the current sampling period) by one sampling period to create the delayed filter output signal from the prior sampling period $y_{k-1}$ which will be used in the calculation which will be executed in the next sampling period associated with the value of the next time index k+1. This means that, in the current sampling period having a time index k when the exponential filter 5 outputs the filter output signal $y_k$, the delayed filter out-

put signal from the prior sampling period $y_{k-1}$, which was computed by the exponential filter 5 during the prior sampling period having prior time index k-1, is supplied from the delay means 7 to the adjusting means 6.

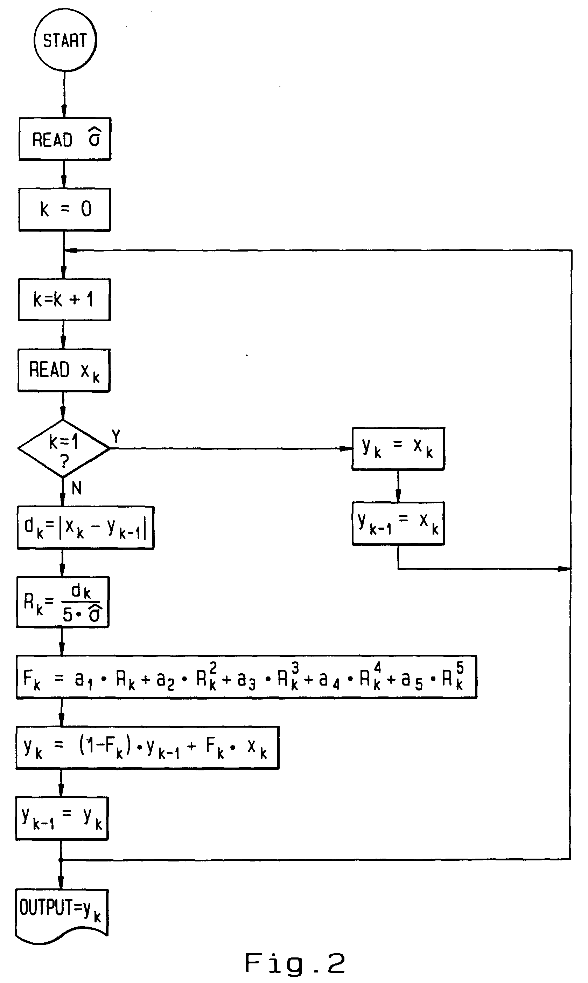

Now, the operation of the adaptive filter 3 is described by referring to Figure 2 showing in a functional diagram (flow chart) the operation of the adaptive filter 3.

An estimate of the standard deviation $\hat{\sigma}$ of the filter input signal $x_k$ has been determined prior to the execution of the adaptive exponential filter method according to any known method. In some applications of the invention, the best mode might be achieved if the estimate of the standard deviation $\hat{\sigma}$ is recomputed either on a periodic basis or upon transition of the operational status of the controlled process 2 (i.e., a shift in process control status from "adding component A" to "adding component B" where component B possesses a number of characteristics which are inherently different from component A).

The operation begins with an initialization part. The estimate of the standard deviation $\hat{\sigma}$ is read. Then the time index k is set to 0, and the first filter input signal $x_k$ is read, and the first filter output signal $y_k$ of the filter is set equal to $x_k$. Similarly, the delayed filter output signal from the prior sampling period $y_{k-1}$ of the filter is also set equal to the filter input signal $x_k$. Then the value of the time index k is increased by one and the filter input signal $x_k$ for the new sampling period is read.

Then the deviation $d_k$ of the filter input signal $x_k$ from the delayed filter output signal from the prior sampling period $y_{k-1}$ of the filter is calculated. This deviation $d_k$ is defined as

$$d_k = |x_k - y_{k-1}| \qquad (3)$$

According to a rule of thumb, the proportion $R_k$ of the deviation $d_k$ to the estimate of the standard deviation $\hat{\sigma}$ is determined by

$$R_k = \frac{d_k}{5 \cdot \hat{\sigma}} \qquad (4)$$

One approach for determination of the discrete filter time constant $F_k$ could be by the following formula:

$$F_k = a_1 R_k + a_2 R_k^2 + a_3 R_k^3 + a_4 R_k^4 + a_5 R_k^5 \qquad (5)$$

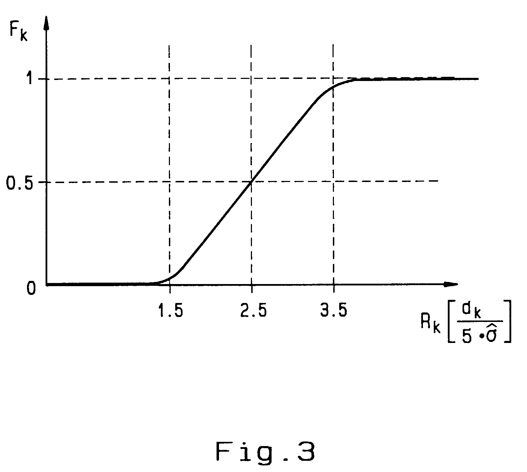

In this formula, the factors $a_1$ to $a_5$ are determined by polynomial interpolation to approximate the functional relationship according to Figure 3. When using the computer system of the applicant, the values could e.g. be (in a preferred embodiment of the invention): $a_1 = 0.697$; $a_2 = -7.705$; $a_3 = 32.66$; $a_4 = -40.38$; $a_5 = 15.73$.

With the above determined discrete filter time constant $F_k$, the filter output signal $y_k$ could be determined according to the above-mentioned formula

$$y_k = (1-F_k) \cdot y_{k-1} + F_k \cdot x_k \qquad (1)$$

Thereafter, the filter output signal $y_k$ is supplied to the combining circuit 4 and, as well, to the delay means 7. Then the value of the time index k is increased by one and the next filter input signal $x_k$ is read and so on.

Figure 3 shows an illustration of an exemplary functional relationship between the discrete filter time constant $F_k$ and the proportion $R_k$ where the values of $R_k$ and $F_k$ are respectively determined according to the above formulas (4) and (5).

In this exemplary functional relationship, the discrete filter time constant $F_k$ is set to zero when the deviation $d_k$ is less than 1.5 times the estimate of the standard deviation, and is set to 1 when the deviation $d_k$ is greater than 3.5 times the estimate of the standard deviation.

This means that, in case of a deviation $d_k$ of less than 1.5 times the estimate of the standard deviation, the filter assumes that the change of process data is not significant, i.e. the change of the measured value is due to pure process noise only and the process itself is steady, so that the filter output signal $y_k$ of the filter is kept at the same value as it was in the prior sampling period.

In case of a deviation $d_k$ of more than 3.5 times the estimate of the standard deviation $\hat{\sigma}$, the filter assumes that a significant change of the process has taken place so that the filter input signal $x_k$ is effectively output by exponential filter 5 in such a manner as to set filter output signal $y_k = x_k$ without any apparent "filtering" modification.

In between these two extremes, the functional relationship between $F_k$ and $R_k$ does not have any discontinuities, as shown in Figure 3. This means that the discrete filter time constant $F_k$ increases steadily from the value zero to the value 1 in response to the increase of the proportion $R_k$. This way of adjusting the adaptive exponential filter 3 is especially advantageous if the controller 1 incorporates a D-controller function (with derivative action).

The above-mentioned lower and upper predetermined values, in Figure 3 depicted as 1.5 and 3.5, can also be determined in other ways, e.g. with 1 as lower and 4 as upper predetermined values. In a preferred embodiment of the invention the functional relationship is symmetrical.

In case the controller 1 comprises no D-controller the functional relationship can have two discontinuities at the above-mentioned lower and upper predetermined values. In this case, the curve can be combined out of three pieces, where $F_k = 0$ if $R_k$ is less than the lower

predetermined value; $F_k = 1$ if $R_k$ is greater than the upper predetermined value; and the lower and upper predetermined values are connected by a straight line.

## Claims

1. Method for adjusting an adaptive exponential filter, especially for noise reduction, the input to which is supplied with a series of time-discrete input signals containing both data and noise,

   wherein an estimate of the standard deviation of the filter input signal has been determined prior to the execution of the method for adjusting the adaptive exponential filter,

   comprising the steps of:

   measuring the deviation between the current filter input signal to the adaptive exponential filter and the prior sample period's output signal from the exponential filter,
   determining the proportion of said deviation to said estimate of the standard deviation, and adjusting the discrete time constant ($F_k$) of the filter in response to said proportion to provide a filter output signal at the output of the adaptive exponential filter.

2. Method as defined in claim 1, wherein the discrete time constant ($F_k$) of the filter is set equal to the value zero if said proportion is less than a first predetermined value.

3. Method as defined in one of claims 1 or 2, wherein the discrete time constant ($F_k$) of the filter is set equal to the value 1 if said proportion is higher than a second predetermined value.

4. Method as defined in one of claims 1 to 3, wherein the discrete time constant ($F_k$) of the filter increases steadily from the value zero to the value 1 in response to the increase of said proportion.

5. Method as defined in one of claims 1 to 4, wherein the functional relationship between the discrete filter time constant ($F_k$) and said proportion has an S-shaped form.

6. Method as defined in claims 2 to 5, wherein the functional relationship is defined by

$$F_k = a_1 R_k + a_2 R_k^2 + a_3 R_k^3 + a_4 R_k^4 + a_5 R_k^5$$

with

$$R_k = \frac{d_k}{5 \cdot \hat{\sigma}}$$

and

$$d_k = |x_k - y_{k-1}|$$

where $x_k$ is the filter input signal and $y_{k-1}$ the delayed filter output signal from the prior sampling period, $\hat{\sigma}$ the estimate of the standard deviation and $a_1$ to $a_5$ are determined by polynomial interpolation.

7. Method as defined in one of claims 1 to 4, wherein the functional relationship between the discrete filter time constant ($F_k$) and said proportion has two discontinuities at said first and second predetermined values.

8. Adaptive exponential filter (3), especially for noise reduction, the input to which is supplied with a series of time-discrete input signals ($x_k$) containing both data and noise and wherein an estimate of the standard deviation of the filter input signal has been determined prior to the operation of the adaptive exponential filter,

   comprising:

   a means for measuring the deviation between the current filter input signal to the adaptive exponential filter and the prior sample period's output signal from the exponential filter,
   a means for determining the proportion of said deviation to said estimate of the standard deviation, and
   a means (6) for adjusting the discrete time constant ($F_k$) of the filter in response to said proportion to provide a filter output signal ($y_k$) at the output of the adaptive exponential filter.

9. Filter as defined in claim 8, wherein the discrete time constant ($F_k$) of the filter is set equal to the value zero if said proportion is less than a first predetermined value.

10. Filter as defined in one of claims 8 or 9, wherein the discrete time constant ($F_k$) of the filter is set equal to the value 1 if said proportion is higher than a second predetermined value.

11. Filter as defined in one of claims 8 to 10, wherein the means (6) for adjusting the discrete time constant of the filter is capable of increasing steadily the discrete time constant ($F_k$) of the filter from the value zero to the value 1 in response to the increase of said proportion above the first predetermined value.

**12.** Filter as defined in one of claims 8 to 11, wherein the functional relationship between the discrete filter time constant ($F_k$) and said proportion has an S-shaped form.

**13.** Filter as defined in one of claims 9 to 12, wherein the functional relationship is defined by

$$F_k = a_1\,R_k + a_2\,R_k^{\,2} + a_3\,R_k^{\,3} + a_4\,R_k^{\,4} + a_5\,R_k^{\,5}$$

with

$$R_k = \frac{d_k}{5\cdot\hat{\sigma}}$$

and

$$d_k = \left|x_k - y_{k-1}\right|$$

where $x_k$ is the filter input signal and $y_{k-1}$ the delayed filter output signal from the prior sampling period, $\hat{\sigma}$ the estimate of the standard deviation and $a_1$ to $a_5$ are determined by polynomial interpolation.

**14.** Filter as defined in one of claims 8 to 11, wherein the functional relationship between the discrete filter time constant ($F_k$) and said proportion has two discontinuities at said first and second predetermined values.

**15.** Use of the adaptive exponential filter as defined in one of claims 8 to 14 in a control loop comprising a controller (1) and a controlled system (2), wherein the series of controlled outputs signals ($x_k$) of the controlled system is supplied as the series of time-discrete filter input signals and the filter output signal ($y_k$) is fed back to the controller.

**16.** Control loop comprising a controller (1) and a controlled system (2) wherein the output signals ($x_k$) of the controlled system are fed back to the controller (1) through a filter (3) as defined in one of claims 8 to 13.

**17.** Method for controlling a control loop comprising a controller and a controlled system wherein the controlled output signals ($x_k$) of the controlled system are fed back to the controller (1) through a filter (3) which is adjusted according to the method as defined in one of claims 1 to 7.

**Patentansprüche**

**1.** Verfahren zum Einstellen eines adaptiven Exponentialfilters, insbesondere zur Rauschverminderung, an dessen Eingang eine Reihe zeitdiskreter Eingangssignale angelegt wird, die sowohl Daten als auch Rauschen enthalten,

wobei eine Schätzung der Standardabweichung des Filter-Eingangssignals vor der Ausführung des Verfahrens zum Einstellen des adaptiven Exponentialfilters ermittelt worden ist, wobei das Verfahren folgende Schritte aufweist:

Messen der Abweichung zwischen dem an das adaptive Exponentialfilter angelegte aktuelle Filter-Eingangssignal und dem Ausgangssignal vom Exponentialfilter aus der vorherigen Abtastperiode, Ermitteln des Verhältnisses der Abweichung zur Schätzung der Standardabweichung, und Einstellen der zeitdiskreten Konstante ($F_k$) des Filters in Reaktion auf das Verhältnis, um am Ausgang des adaptiven Exponentialfilters ein Filter-Ausgangssignal zur Verfügung zu stellen.

**2.** Verfahren nach Anspruch 1, bei dem die diskrete Zeitkonstante ($F_k$) des Filters gleich dem Wert Null gesetzt wird, wenn das Verhältnis kleiner als ein erster vorgegebener Wert ist.

**3.** Verfahren nach Anspruch 1 oder 2, bei dem die diskrete Zeitkonstante ($F_k$) des Filters gleich dem Wert Eins gesetzt wird, wenn das Verhältnis größer als ein zweiter vorgegebener Wert ist.

**4.** Verfahren nach einem der Ansprüche 1 bis 3, bei dem die diskrete Zeitkonstante ($F_k$) des Filters in Reaktion auf das Ansteigen des Verhältnisses stetig vom Wert Null auf den Wert Eins ansteigt.

**5.** Verfahren nach einem der Ansprüche 1 bis 4, bei dem die funktionale Beziehung zwischen der diskreten Filter-Zeitkonstante ($F_k$) und dem Verhältnis eine S-Form aufweist.

**6.** Verfahren nach den Ansprüchen 2 bis 5, bei dem die funktionale Beziehung definiert ist durch

$$F_k = a_1\,R_k + a_2\,R_k^{\,2} + a_3\,R_k^{\,3} + a_4\,R_k^{\,4} + a_5\,R_k^{\,5}$$

mit

$$R_k = \frac{d_k}{5x\hat{\sigma}}$$

und

$$d_k = |x_k - y_{k-1}|$$

wobei $x_k$ das Filter-Eingangssignal und $y_{k-1}$ das verzögerte Filter-Ausgangssignal aus der vorherigen Abtastperiode und $\hat{\sigma}$ die Schätzung der Standardabweichung ist, und wobei $a_1$ bis $a_5$ durch polynome Interpolation ermittelt werden.

7. Verfahren nach einem der Ansprüche 1 bis 4, bei dem die funktionale Beziehung zwischen der diskreten Filter-Zeitkonstante ($F_k$) und dem Verhältnis beim ersten und zweiten vorgegebenen Wert zwei Diskontinuitäten aufweist.

8. Adaptives Exponentialfilter (3), insbesondere zur Rauschverminderung, an dessen Eingang eine Reihe zeitdiskreter Eingangssignale ($x_k$) angelegt wird, die sowohl Daten als auch Rauschen enthalten, und bei dem eine Schätzung der Standardabweichung des Filter-Eingangssignals vor dem Betrieb des adaptiven Exponentialfilters ermittelt worden ist,
   wobei das Filter folgendes umfaßt:

   eine Einrichtung zum Messen der Abweichung zwischen dem an das adaptive Exponentialfilter angelegte aktuelle Filter-Eingangssignal und dem Ausgangssignal vom Exponentialfilter aus der vorherigen Abtastperiode,
   eine Einrichtung zum Ermitteln des Verhältnisses der Abweichung zur Schätzung der Standardabweichung, und
   eine Einrichtung (6) zum Einstellen der diskreten Zeitkonstante ($F_k$) des Filters in Reaktion auf das Verhältnis, um am Ausgang des adaptiven Exponentialfilters ein Filter-Ausgangssignal ($y_k$) zur Verfügung zu stellen.

9. Filter nach Anspruch 8, bei dem die diskrete Zeitkonstante ($F_k$) des Filters gleich dem Wert Null gesetzt wird, wenn das Verhältnis kleiner als ein erster vorgegebener Wert ist.

10. Filter nach Anspruch 8 oder 9, bei dem die diskrete Zeitkonstante ($F_k$) des Filters gleich dem Wert Eins gesetzt wird, wenn das Verhältnis größer als ein zweiter vorgegebener Wert ist.

11. Filter nach einem der Ansprüche 8 bis 10, bei dem die Einrichtung (6) zum Einstellen der diskreten Zeitkonstante des Filters in der Lage ist, die diskrete Zeitkonstante ($F_k$) des Filters in Reaktion auf das Ansteigen des Verhältnisses über den ersten vorgegebenen Wert stetig vom Wert Null auf den Wert Eins anzuheben.

12. Filter nach einem der Ansprüche 8 bis 11, bei dem die funktionale Beziehung zwischen der diskreten Filter-Zeitkonstante ($F_k$) und dem Verhältnis eine S-Form aufweist.

13. Filter nach einem der Ansprüche 9 bis 12, bei dem die funktionale Beziehung definiert ist durch

$$F_k = a_1 R_k + a_2 R_k^2 + a_3 R_k^3 + a_4 R_k^4 + a_5 R_k^5$$

mit

$$R_k = \frac{d_k}{5x\hat{\sigma}}$$

und

$$d_k = |x_k - y_{k-1}|$$

wobei $x_k$ das Filter-Eingangssignal und $y_{k-1}$ das verzögerte Filter-Ausgangssignal aus der vorherigen Abtastperiode und $\hat{\sigma}$ die Schätzung der Standardabweichung ist, und wobei $a_1$ bis $a_5$ durch polynome Interpolation ermittelt werden.

14. Filter nach einem der Ansprüche 8 bis 11, bei dem die funktionale Beziehung zwischen der diskreten Filter-Zeitkonstante ($F_k$) und dem Verhältnis beim ersten und zweiten vorgegebenen Wert zwei Diskontinuitäten aufweist.

15. Verwendung des adaptiven Exponentialfilters gemäß einem der Ansprüche 8 bis 14 in einem Regelkreis, der eine Steuereinrichtung (1) und ein gesteuertes System (2) aufweist, wobei die Reihe von gesteuerten Ausgangssignalen ($x_k$) des gesteuerten Systems als die Reihe von zeitdiskreten Filter-Eingangssignalen zugeführt und das Filter-Ausgangssignal ($y_k$) zur Steuereinrichtung zurückgeführt wird.

16. Regelkreis mit einer Steuereinrichtung (1) und einem gesteuerten Sytem (2), bei dem die Ausgangssignale ($x_k$) des gesteuerten Systems über ein Filter (3) gemäß den Ansprüchen 8 bis 13 zur Steuereinrichtung (1) zurückgeführt werden.

17. Verfahren zur Steuerung eines Regelkreises, der eine Steuereinrichtung und ein gesteuertes System umfaßt, und bei dem die gesteuerten Ausgangssignale ($x_k$) des gesteuerten Systems über ein Filter (3), das gemäß dem Verfahren nach einem der Ansprüche 1 bis 7 eingestellt wurde, zur Steuereinrichtung (1) zurückgeführt werden.

## Revendications

1. Procédé pour ajuster un filtre exponentiel adaptatif, en particulier en vue d'une diminution du bruit, à l'entrée duquel est appliquée une série de signaux d'entrée discrets en temps contenant à la fois des données et du bruit, dans lequel une estimation de l'écart type du signal d'entrée du filtre a été déterminée avant l'exécution du procédé d'ajustement du filtre exponentiel adaptatif,

comprenant les étapes consistant:

à mesurer l'écart entre le signal d'entrée actuel du filtre appliqué au filtre exponentiel adaptatif et le signal de sortie de la période d'échantillonnage précédente provenant du filtre exponentiel,
à déterminer la proportion dudit écart par rapport à ladite estimation de l'écart type, et
à ajuster la constante de temps discrète ($F_k$) du filtre en réponse à ladite proportion afin de produire un signal de sortie du filtre à la sortie du filtre exponentiel adaptatif.

2. Procédé selon la revendication 1, dans lequel la constante de temps discrète ($F_k$) du filtre est mise à la valeur zéro si ladite proportion est inférieure à une première valeur prédéterminée.

3. Procédé selon la revendication 1 ou 2, dans lequel la constante de temps discrète ($F_k$) du filtre est mise à la valeur 1 si ladite proportion est supérieure à une deuxième valeur prédéterminée.

4. Procédé selon l'une des revendications 1 à 3, dans lequel la constante de temps discrète ($F_k$) du filtre augmente régulièrement à partir de la valeur zéro jusqu'à la valeur 1 en réponse à l'augmentation de ladite proportion.

5. Procédé selon l'une des revendications 1 à 4, dans lequel la relation fonctionnelle entre la constante de temps discrète de filtre ($F_k$) et ladite proportion possède une forme en S.

6. Procédé selon l'une des revendications 2 à 5, dans lequel la relation fonctionnelle est définie par:

$$F_k = a_1 R_k + a_2 R_k^2 + a_3 R_k^3 + a_4 R_k^4 + a_5 R_k^5$$

avec

$$R_k = \frac{d_k}{5 \cdot \hat{\sigma}}$$

et

$$d_k = \left| x_k - y_{k-1} \right|$$

où $x_k$ est le signal d'entrée du filtre et $y_{k-1}$ le signal de sortie retardé du filtre de la période d'échantillonnage précédente, $\hat{\sigma}$ l'estimation de l'écart type et $a_1$ à $a_5$ sont déterminés par une interpolation polynomiale.

7. Procédé selon l'une des revendications 1 à 4, dans lequel la relation fonctionnelle entre la constante de temps discrète ($F_k$) du filtre et ladite proportion possède deux discontinuités auxdites première et deuxième valeurs prédéterminées.

8. Filtre exponentiel adaptatif (3), en particulier pour une diminution du bruit, à l'entrée duquel est appliquée une série de signaux d'entrée discrets en temps ($x_k$) contenant à la fois des données et du bruit et dans lequel une estimation de l'écart type du signal d'entrée du filtre a été déterminée avant le fonctionnement du filtre exponentiel adaptatif, comprenant:

un moyen pour mesurer l'écart entre le signal d'entrée actuel du filtre appliqué au filtre exponentiel adaptatif actuel et le signal de sortie de la période d'échantillonnage précédente provenant du filtre exponentiel,
un moyen pour déterminer la proportion dudit écart par rapport à ladite estimation d'écart type, et
un moyen (6) pour ajuster la constante de temps discrète ($F_k$) du filtre en réponse à ladite proportion afin de produire un signal de sortie de filtre ($y_k$) à la sortie du filtre exponentiel adaptatif.

9. Filtre selon la revendication 8, dans lequel la constante de temps discrète ($F_k$) du filtre est mise à la valeur zéro si la proportion est inférieure à une première valeur prédéterminée.

10. Filtre selon la revendication 8 ou 9, dans lequel la constante de temps discrète ($F_k$) du filtre est mise à la valeur 1 si ladite proportion est supérieure à une deuxième valeur prédéterminée.

11. Filtre selon l'une des revendications 8 à 10, dans lequel le moyen (6) pour ajuster la constante de temps discrète du filtre est capable d'augmenter régulièrement la constante de temps discrète ($F_k$) du filtre de la valeur zéro jusqu'à la valeur 1 en réponse à l'augmentation de ladite proportion au-dessus de la première valeur prédéterminée.

12. Filtre selon l'une des revendications 8 à 11, dans lequel la relation fonctionnelle entre la constante de temps du filtre discrète ($F_k$) et ladite proportion possède une forme en S.

13. Filtre selon l'une des revendications 9 à 12, dans lequel la relation fonctionnelle est définie par:

$$F_k = a_1 R_k + a_2 R_k^2 + a_3 R_k^3 + a_4 R_k^4 + a_5 R_k^5$$

avec

$$R_k = \frac{d_k}{5 \cdot \hat{\sigma}}$$

et

$$d_k = \left| x_k - y_{k-1} \right|$$

où $x_k$ est le signal d'entrée du filtre et $y_{k-1}$ le signal de sortie de filtre retardé de la période d'échantillonnage précédente, $\hat{\sigma}$ l'estimation de l'écart type et $a_1$ à $a_5$ sont déterminés par interpolation polynomiale.

14. Filtre selon l'une des revendications 8 à 11, dans lequel la relation fonctionnelle entre la constante de temps discrète de filtre ($F_k$) et ladite proportion possède deux discontinuités auxdites première et deuxième valeurs prédéterminées.

15. Utilisation du filtre exponentiel adaptatif selon l'une des revendications 8 à 14 dans un circuit de réglage comprenant un dispositif de commande (1) et un système commandé (2), dans lequel la série de signaux de sortie commandés ($x_k$) du système commandé est appliquée en tant que série de signaux d'entrée de filtre discrets en temps et le signal de sortie du filtre ($y_k$) est renvoyé vers le dispositif de commande.

16. Circuit de réglage comprenant un dispositif de commande (1) et un système commandé (2) dans lequel les signaux de sortie ($x_k$) du système commandé sont renvoyés vers le dispositif de commande (1) à travers un filtre (3) tel que défini dans l'une des revendications 8 à 13.

17. Procédé pour commander un circuit de réglage comprenant un dispositif de commande et un système commandé dans lequel les signaux de sortie commandés ($x_k$) du système commandé sont renvoyés vers le dispositif de commande (1) à travers un filtre (3) qui est ajusté selon le procédé défini dans l'une des revendications 1 à 7.

Fig.1

START

READ $\hat{\sigma}$

$k = 0$

$k = k + 1$

READ $x_k$

$k = 1$ ? — Y → $y_k = x_k$ → $y_{k-1} = x_k$

N

$d_k = |x_k - y_{k-1}|$

$R_k = \dfrac{d_k}{5 \cdot \hat{\sigma}}$

$F_k = a_1 \cdot R_k + a_2 \cdot R_k^2 + a_3 \cdot R_k^3 + a_4 \cdot R_k^4 + a_5 \cdot R_k^5$

$y_k = (1 - F_k) \cdot y_{k-1} + F_k \cdot x_k$

$y_{k-1} = y_k$

OUTPUT $= y_k$

Fig.2

11

Fig.3